# EUROPEAN PATENT APPLICATION

(11) **EP 4 716 402 A1**
(43) Date of publication of application: **25.03.2026**
(21) Application number: 25202376.7
(22) Date of filing: 16.09.2025
(51) Int. Cl.: H10D 1/20, H10B 43/40

(54) **SEMICONDUCTOR DEVICE AND DATA STORAGE SYSTEM INCLUDING THE SAME**

(30) Priority: 19.09.2024 KR 20240126937
(71) Applicant: SAMSUNG ELECTRONICS CO., LTD., Yeongtong-gu Suwon-si, Gyeonggi-do 16677 (KR)
(72) Inventor: KIM, Jiyoung, 16677 Suwon-si, Gyeonggi-do (KR); BYUN, Jindo, 16677 Suwon-si, Gyeonggi-do (KR); KANG, Bumkyu, 16677 Suwon-si, Gyeonggi-do (KR); KIM, Junhyoung, 16677 Suwon-si, Gyeonggi-do (KR); SUNG, Sukkang, 16677 Suwon-si, Gyeonggi-do (KR); LEE, Sehoon, 16677 Suwon-si, Gyeonggi-do (KR)
(74) Representative: Kuhnen & Wacker Patent- und Rechtsanwaltsbüro PartG mbB

(57) **Abstract**

A semiconductor device and a data storage system including the same are provided. The semiconductor device (CH) includes: a lower structure (LS); and an upper structure (US) on the lower structure, wherein the upper structure comprises a first lower conductive pattern (204a); a second lower conductive pattern (204b), provided at a same level; a lower insulating structure (210) on the lower structure and on side surfaces of the first and second lower conductive patterns, having an upper surface at a level farther from the lower structure than that of the first and second lower conductive patterns; an upper conductive pattern (215) comprising a first portion (215b, 215c) on an upper surface of the lower insulating structure, a second portion (215a) extending from the first portion and contacting the upper surface of the first lower conductive pattern exposed by a first opening in the lower insulating structure, wherein at least a portion of the first portion of the upper conductive pattern has a spiral coil shape in a plan view.

## Description

### BACKGROUND

The present disclose relates to a semiconductor device and a data storage system including the same.

In electronic systems that require data storage, semiconductor devices capable of storing large amounts of data are in demand. Accordingly, methods for increasing a data storage capacity of semiconductor devices are being studied. For example, as a method for increasing a data storage capacity of semiconductor devices, a semiconductor device including memory cells arranged three-dimensionally instead of two-dimensionally is being proposed.

### SUMMARY

One or more example embodiments provide a semiconductor device in which performance may be improved.

One or more example embodiments also provide a data storage system including the semiconductor device.

According to an aspect of an example embodiment, a semiconductor device includes: a lower structure including a first structure including a peripheral circuit, and a second structure including a memory cell array area and an outer peripheral area outside the memory cell array area and vertically overlapping the first structure; and an upper structure on the lower structure. The upper structure includes: a first lower conductive pattern; a second lower conductive pattern, provided at a same level as the first lower conductive pattern, and including a first connection region, a second connection region, and an intermediate region between the first connection region and the second connection region; a lower insulating structure provided on the lower structure, on side surfaces of the first lower conductive pattern and the second lower conductive pattern, having an upper surface at a level farther from the lower structure than upper surfaces of the first lower conductive pattern and the second lower conductive pattern, and defining a first opening exposing at least a portion of an upper surface of the first lower conductive pattern and a second opening exposing at least a portion of an upper surface of the first connection region of the second lower conductive pattern; an upper conductive pattern including a first portion provided on an upper surface of the lower insulating structure, a second portion extending from the first portion and contacting the upper surface of the first lower conductive pattern exposed by the first opening, and a third portion extending from the first portion and contacting the upper surface of the first connection region of the second lower conductive pattern exposed by the second opening; and an upper insulating structure provided on the upper conductive pattern and defining a pad opening exposing at least a portion of an upper surface of the second portion of the upper conductive pattern. At least a portion of the first portion of the upper conductive pattern defines a spiral coil shape in a plan view.

According to another aspect of an example embodiment, a semiconductor device includes: a lower structure having a memory cell array area and an outer peripheral area outside the memory cell array area; and an upper structure on the lower structure. The upper structure includes: a pad including a first lower conductive pattern provided on the outer peripheral area and an upper conductive pattern on the first lower conductive pattern; and an inductor portion extending from the upper conductive pattern and overlapping the memory cell array area, and defining a spiral coil shape at a level farther from the lower structure than the first lower conductive pattern.

According to another aspect of an example embodiment, a data storage system includes: a semiconductor device including an input/output pad; and a controller electrically connected to the semiconductor device through the input/output pad and configured to control the semiconductor device. The semiconductor device includes: a lower structure including a first structure including a peripheral circuit, and a second structure including a memory cell array area and an outer peripheral area outside the memory cell array area and vertically overlapping the first structure; and an upper structure on the lower structure. The upper structure includes: a first lower conductive pattern; a second lower conductive pattern, provided at a same level as the first lower conductive pattern, and including a first connection region, a second connection region, and an intermediate region between the first connection region and the second connection region; a lower insulating structure provided on the lower structure, on side surfaces of the first lower conductive pattern and the second lower conductive pattern, having an upper surface provided at a level farther from the lower structure than upper surfaces of the first lower conductive pattern and the second lower conductive pattern, and defining a first opening exposing at least a portion of an upper surface of the first lower conductive pattern and a second opening exposing at least a portion of an upper surface of the first connection region of the second lower conductive pattern; an upper conductive pattern including a first portion provided on an upper surface of the lower insulating structure, a second portion extending from the first portion and contacting the upper surface of the first lower conductive pattern exposed by the first opening, and a third portion extending from the first portion and contacting the upper surface of the first connection region of the second lower conductive pattern exposed by the second opening; and an upper insulating structure provided on the upper conductive pattern and defining a pad opening exposing at least a portion of an upper surface of the second portion of the upper conductive pattern. At least a portion of the second portion of the upper conductive pattern defines a spiral coil shape in a plan view.

### BRIEF DESCRIPTION OF DRAWINGS

The above and other aspects and features will become more apparent from the following detailed description, taken in conjunction with the accompanying drawings, in which:
FIGS. 1 to 4 are drawings illustrating a semiconductor device according to example embodiments;
FIGS. 5, 6A, 6B, 6C, and 7 are drawings illustrating semiconductor devices according to an example embodiment;
FIG. 8 is a cross-sectional view illustrating a semiconductor device according to an example embodiment;
FIGS. 9 and 10 are cross-sectional views illustrating semiconductor devices according to example embodiments;
FIGS. 11 and 12 are drawings illustrating a semiconductor device according to an example embodiment;
FIG. 13A is a plan view illustrating a semiconductor device according to an example embodiment;
FIG. 13B is a plan view illustrating a semiconductor device according to an example embodiment;
FIG. 13C is a plan view illustrating a semiconductor device according to an example embodiment; and
FIG. 14 is a process flow diagram illustrating an illustrative example of a method of forming a semiconductor device according to example embodiments.

### DETAILED DESCRIPTION

Hereinafter, example embodiments are described in detail with reference to the accompanying drawings. Terms such as "upper," "intermediate," "middle," "lower," "inner," "outer," and the like may be replaced with other terms, such as "first," "second," "third," and the like to describe the elements of the specification. Terms such as "first", "second" and "third" may be used to describe various elements, but the elements are not limited by the terms, and a "first element" may be referred to as a "second element," or may be named by another term that may be distinguished from the other elements. Embodiments described herein are example embodiments, and thus, the present disclosure is not limited thereto, and may be realized in various other forms. Each example embodiment provided in the following description is not excluded from being associated with one or more features of another example or another embodiment also provided herein or not provided herein but consistent with the present disclosure.

The size ratio, width ratio, length ratio, and the like between the elements depicted in the drawings may be understood from the elements depicted in the drawings even without a separate explanation.

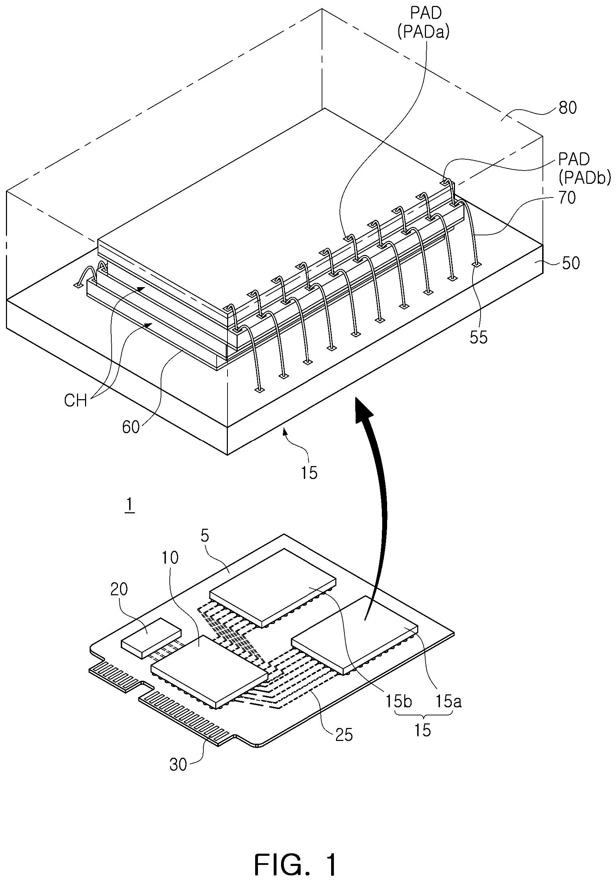

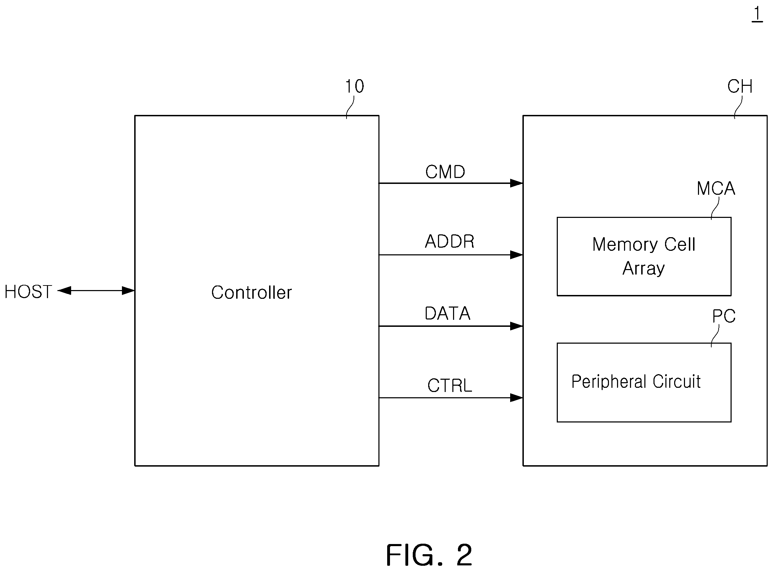

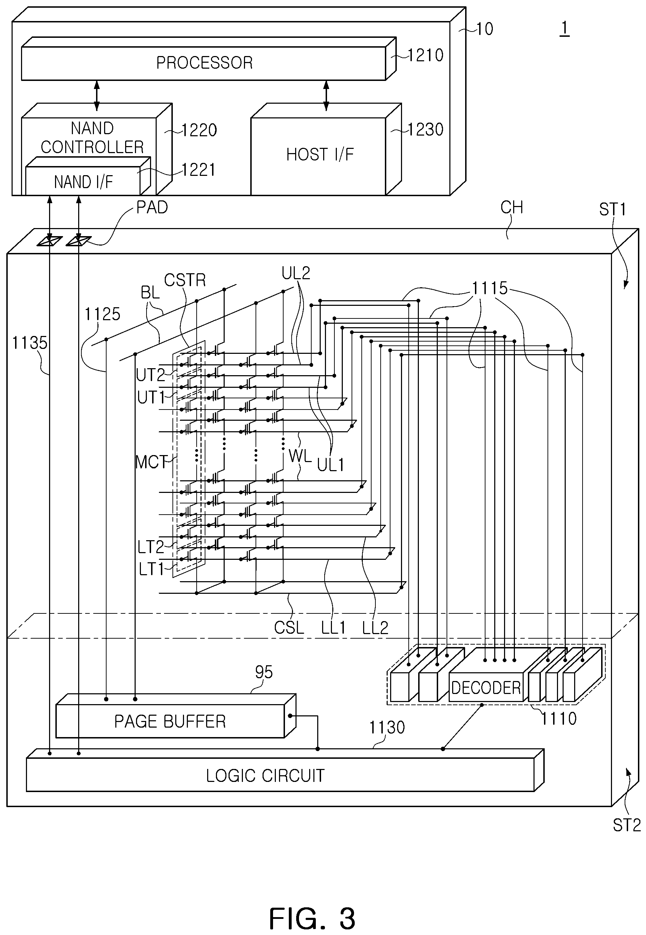

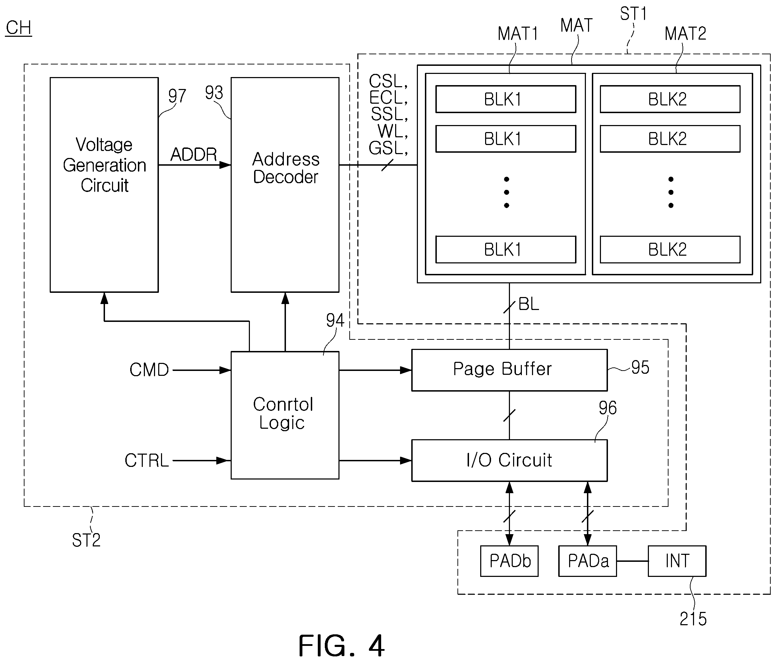

Referring to FIGS. 1 to 4, a semiconductor device according to example embodiments and a data storage system including the same will be described. FIG. 1 is a perspective view schematically illustrating a data storage system 1 including a semiconductor device CH according to example embodiments, FIG. 2 is a block diagram schematically illustrating a data storage system 1 including a semiconductor device CH according to example embodiments, FIG. 3 is a drawing schematically illustrating a data storage system 1 including a semiconductor device CH according to an example embodiment, and FIG. 4 is a block diagram schematically illustrating a semiconductor device CH according to example embodiments.

Referring to FIGS. 1 to 4, a data storage system 1 according to an example embodiment may include a main substrate 5, a controller 10 mounted on the main substrate 5, one or more semiconductor packages 15, and a dynamic random access memory (DRAM) 20. The semiconductor package 15 and the DRAM 20 may be connected to the controller 10 by interconnection patterns 25 formed on the main substrate 5.

The main substrate 5 may include a connector 30 including a plurality of pins coupled with an external host HOST. The number and arrangement of the plurality of pins in the connector 30 may vary depending on the communication interface between the data storage system 1 and the external host HOST.

In example embodiments, the data storage system 1 may communicate with the external host according to any one of interfaces such as Universal Serial Bus (USB), Peripheral Component Interconnect Express (PCI-Express), Serial Advanced Technology Attachment (SATA), and M-Phy for Universal Flash Storage (UFS).

In example embodiments, the data storage system 1 may be operated by power supplied from the external host HOST through the connector 30.

The data storage system 1 may further include a Power Management Integrated Circuit (PMIC) that distributes power supplied from the external host HOST to the controller 10 and the semiconductor package 15.

The controller 10 may write data to the semiconductor package 15 or read data from the semiconductor package 15, and may improve the operation speed of the data storage system 1.

The DRAM 20 may be a buffer memory for mitigating the speed difference between the semiconductor package 15, which is a data storage space, and an external host. The DRAM 20 included in the data storage system 1 may also function as a type of cache memory, and may also provide a space for temporarily storing data in a control operation for the semiconductor package 15. When the DRAM 20 is included in the data storage system 1, the controller 10 may further include a DRAM controller for controlling the DRAM 20 in addition to a NAND controller 1220 for controlling the semiconductor package 15.

The semiconductor package 15 may include first and second semiconductor packages 15a and 15b that are spaced apart from each other. The first and second semiconductor packages 15a and 15b may each include a plurality of semiconductor devices CH. The semiconductor devices CH may also be referred to as semiconductor chips.

Each of the first and second semiconductor packages 15a and 15b may include a package substrate 50, the semiconductor devices CH on the package substrate 50, adhesive layers 60 disposed on respective lower surfaces of the semiconductor devices CH, a connection structure (or an external connection structure) 70 electrically connecting the semiconductor devices CH and the package substrate 50, and a molding layer 80 covering the semiconductor devices CH and the connection structure 70, on the package substrate 50.

The package substrate 50 may be a printed circuit board including package upper pads 55. Each of the semiconductor devices CH may include pads PAD. The pads PAD may include input/output pads and power pads. The power pads may include VDD pads and GND pads.

The pads PAD may include first pads PADa electrically connected to an upper conductive pattern 215 and second pads PADb not electrically connected to the upper conductive pattern 215.

The upper conductive pattern 215 may include an inductor INT or a plurality of inductors INT, which may have a T-coil or spiral coil shape.

The inductor INT in the upper conductive pattern 215 may reduce signal distortion in high-speed data transmission and reduce the possibility of data loss or error occurrence.

Among the pads PAD, if the input/output pad PADa is connected to the inductor INT, the signal quality in signal transmission may be improved, and the bandwidth of the signal may be widened so that more data may be transmitted more quickly. For example, in the case in which the power pad PADa among the pads PAD is connected to the upper conductive pattern 215, this case may be useful for filtering high-frequency noise, and therefore, noise of the power line in the power supply circuit may be reduced.

In example embodiments, the connection structure 70 may include bonding wires that electrically connect the pads PAD and the package upper pads 55. Therefore, in each of the first and second semiconductor packages 15a and 15b, the semiconductor devices CH may be electrically connected to each other in a bonding wire manner, and may be electrically connected to the package upper pads 55 of the package substrate 50.

According to example embodiments, in the respective first and second semiconductor packages 15a and 15b, the semiconductor devices CH may be electrically connected to each other by a connection structure including a through silicon via (TSV) instead of the connection structure 70 of the bonding wire type.

In example embodiments, the controller 10 and the semiconductor devices CH may be included in one package. For example, the controller 10 and the semiconductor devices CH may be mounted on a separate interposer substrate different from the main substrate 5, and the controller 10 and the semiconductor devices CH may be connected to each other by an interconnection formed on the interposer substrate.

The controller 10 may write data DATA to the semiconductor device CH or read data DATA stored in the semiconductor device CH. The controller 10 may transmit a command CMD, an address ADDR, a control signal CTRL, and data DATA to the semiconductor devices CH to write data DATA to the semiconductor device CH. The controller 10 may transmit a command CMD, an address ADDR, and a control signal CTRL to the semiconductor device CH to read data DATA stored in the semiconductor device CH.

The semiconductor device CH may include nonvolatile memory devices such as NAND flash memory, phase change memory (PRAM), resistive memory (ReRAM), magneto-resistive memory (MRAM), or ferroelectric memory (FRAM). The semiconductor device CH may perform operations such as writing, reading, and erasing data DATA in response to signals received from the controller 10.

Each of the semiconductor devices CH may include a memory structure ST1 and a peripheral structure ST2 vertically overlapping the memory structure ST1. In the respective semiconductor devices CH, the memory structure ST1 may include a memory mat MAT. In the respective semiconductor devices CH, the memory structure ST1 may include a plurality of memory mats MAT1 and MAT2 spaced apart from each other.

Hereinafter, a description will be given with reference to one semiconductor device CH.

Each of the plurality of memory mats MAT1 and MAT2 may include a plurality of memory blocks. For example, a first memory mat MAT1 among the plurality of memory mats MAT1 and MAT2 may include a plurality of first memory blocks BLK1, and a second memory mat MAT2 among the plurality of memory mats MAT1 and MAT2 may include a plurality of second memory blocks BLK2.

Each of the plurality of memory mats MAT1 and MAT2 may include a memory cell array area MCA including memory cells arranged three-dimensionally. For example, in the memory structure ST1, the first and second memory blocks BLK1 and BLK2 may include memory cells arranged three-dimensionally and capable of storing data.

The peripheral structure ST2 may include a peripheral circuit PC. The peripheral circuit PC may include an address decoder (i.e., an address decoder circuit) 93, a control logic (i.e., a control logic circuit) 94, a page buffer (i.e., a page buffer circuit) 95, an input/output circuit (I/O) 96, and a voltage generation circuit 97. Therefore, in the semiconductor device CH, the memory structure ST1 may include a plurality of memory mats MAT1 and MAT2 including the memory cell array area MCA, and the peripheral structure ST2 may include the peripheral circuit PC.

The memory structure ST1 may further include word lines WL, string select lines SSL, ground select lines GSL, bit lines BL, erase control lines ECL, and a common source CSL.

The memory cells of the memory cell array area MCA of each of the plurality of memory mats MAT1 and MAT2 may be electrically connected to the address decoder 93 of the peripheral circuit PC through the word lines WL, the string select lines SSL, the ground select lines GSL, and the common source CSL, and may be electrically connected to the page buffer 95 of the peripheral circuit PC through the bit lines BL.

The address decoder 93 may select one of the first and second memory blocks BLK1 and BLK2. The address decoder 93 may select one of the word lines WL of the selected memory block. The address decoder 93 may transfer voltages provided from the voltage generation circuit 97 to the word line WL or the select lines SSL and GSL of the selected memory block. The address decoder 93 may transfer a program voltage of a positive (+) high voltage to the selected word line during a program operation, and may transfer an erase voltage of a positive (+) high voltage to the bulk of the selected memory block during an erase operation.

The control logic 94 may receive a command CMD and a control signal CTRL from the controller 10, and control the address decoder 93, the page buffer 95, and the input/output circuit 96 in response to the received signals. The control logic 94 may control the voltage generation circuit 97 that generates various voltages required for the semiconductor device CH to operate. For example, the control logic 94 may adjust the voltage level provided to the word lines WL and the bit lines BL when performing a memory operation such as a program operation or an erase operation.

The voltage generation circuit 97 may generate various levels of voltages such as a plurality of selected read voltages, a plurality of unselected read voltages, a plurality of program pulses, a plurality of pass voltages, and a plurality of erase pulses according to the control of the control logic 94 and provide the voltages to the address decoder 93 and the first and second memory blocks BLK1 and BLK2. For example, the voltage generation circuit 97 may generate a positive (+) high voltage corresponding to the plurality of program pulses or the plurality of erase pulses. The voltage generation circuit 97 may include a charge pump including at least one pumping capacitor to generate various levels of voltages as described above.

The page buffer 95 may operate as a write driver or a sense amplifier depending on the operation mode. During a read operation, the page buffer 95 may sense a bit line BL of a selected memory cell among the three-dimensionally arranged memory cells in the first and second memory blocks BLK1 and BLK2 under the control of the control logic 94. The sensed data may be stored in latches provided inside the page buffer 95. The page buffer 95 may dump data stored in the latches to the input/output circuit 96 under the control of the control logic 94.

The input/output circuit 96 may temporarily store commands CMD, addresses ADDR, control signals CTRL, and data DATA provided from the outside of the semiconductor devices CH through the pads PAD. The input/output circuit 96 may temporarily store read data of the semiconductor device CH and output the data to the outside through the pads PAD at a designated time.

The data storage system 1 may be a storage device including the semiconductor device CH or an electronic device including the storage device. For example, the data storage system 1 may be a solid state drive (SSD) device, a Universal Serial Bus (USB) device, a computing system, a medical device, or a communication device including one or more semiconductor devices CH.

The peripheral structure ST2 may be a peripheral circuit structure or peripheral circuit area including a decoder circuit 1110, a page buffer 95, and a logic circuit 1130.

The memory structure ST1 may include a bit line BL, a common source CSL, word lines WL, first and second upper gate lines UL1 and UL2, first and second lower gate lines LL1 and LL2, and memory cell strings CSTR between the bit line BL and the common source CSL.

In the memory structure ST1, each of the plurality of memory mats MAT1 and MAT2 may include the bit line BL, the common source CSL, the word lines WL, the first and second upper gate lines UL1 and UL2, the first and second lower gate lines LL1 and LL2, and the memory cell strings CSTR.

The first lower gate line LL1 may be disposed at a higher level than the common source CSL. The second lower gate line LL2 may be disposed at a higher level than the first lower gate line LL1. The word lines WL may be disposed at a higher level than the second lower gate line LL2. The first upper gate line UL1 may be disposed at a higher level than the word lines WL. The second upper gate line UL2 may be disposed at a higher level than the first upper gate line UL1.

In the memory structure ST1, the respective memory cell strings CSTR may include lower transistors LT1 and LT2 adjacent to the common source CSL, upper transistors UT1 and UT2 adjacent to the bit line BL, and a plurality of memory cell transistors MCT disposed between the lower transistors LT1 and LT2 and the upper transistors UT1 and UT2.

The number of the lower transistors LT1 and LT2 and the number of the upper transistors UT1 and UT2 may vary depending on example embodiments. The plurality of memory cell transistors MCT may include data storage areas capable of storing information (data).

In example embodiments, the upper transistors UT1 and UT2 may include string select transistors, and the lower transistors LT1 and LT2 may include ground select transistors. The lower gate lines LL1 and LL2 may be gate electrodes of the lower transistors LT1 and LT2, respectively. The word lines WL may be gate electrodes of the memory cell transistors MCT, and the upper gate lines UL1 and UL2 may be gate electrodes of the upper transistors UT1 and UT2, respectively.

In example embodiments, the lower transistors LT1 and LT2 may include a first lower transistor LT1 and a second lower transistor LT2 on the first lower transistor LT1. The first and second lower transistors LT1 and LT2 may be connected in series. The first lower transistor LT1 may be a lower erase control transistor, and the second lower transistor LT2 may be a lower select transistor, for example, a ground select transistor. The first lower gate line LL1 may be a lower erase control gate electrode of the lower erase control transistor LT1, and the second lower gate line LL2 may be a lower select gate electrode of the lower select transistor LT2.

The first and second lower gate lines LL1 and LL2, the word lines WL, and the first and second upper gate lines UL1 and UL2 may be gate electrodes.

In example embodiments, the upper transistors UT1 and UT2 may include a first upper transistor UT1 and a second upper transistor UT2 on the first upper transistor UT1. The first and second upper transistors UT1 and UT2 may be connected in series.

In an example, the first upper transistor UT1 may be an upper erase control transistor, and the second upper transistor UT2 may be an upper select transistor, for example, a string select transistor. In this case, the first upper gate line UL1 may be an upper erase control gate electrode of the upper erase control transistor UT1, and the second upper gate line UL2 may be a string select gate electrode of the string select transistor UT2.

At least one of the lower erase control transistor LT1 and the upper erase control transistor UT1 may be used for an erase operation that erases data stored in the memory cell transistors MCT by utilizing a gate induced drain leakage (GIDL) phenomenon.

In another embodiment, the first upper transistor UT1 may be an upper select transistor, for example, a string select transistor, and the second upper transistor UT2 may be an upper erase control transistor. In this case, the first upper gate line UL1 may be a string select gate electrode of the string select transistor UT1, and the second upper gate line UL2 may be an upper erase control gate electrode of the upper erase control transistor UT2.

In example embodiments, the common source CSL, the first and second lower gate lines LL1 and LL2, the word lines WL, and the first and second upper gate lines UL1 and UL2 may be electrically connected to the decoder circuit 1110 through routing interconnection structures 1115 that extend from within the memory structure ST1 to the peripheral structure ST2.

In example embodiments, the routing interconnection structures 1115 may be connected to pad areas of the first and second lower gate lines LL1 and LL2, pad areas of the word lines WL, and pad areas of the first and second upper gate lines UL1 and UL2.

The bit lines BL may be electrically connected to the page buffer 95 through a routing interconnection structure 1125 extending from the peripheral structure ST2 to the memory structure ST1.

In the peripheral structure ST2, the decoder circuit 1110 and the page buffer 95 may perform a control operation on at least one selected memory cell transistor among the plurality of memory cell transistors MCT. The decoder circuit 1110 and the page buffer 95 may be controlled by the logic circuit 1130.

The semiconductor device CH may communicate with the controller 10 through the pads PAD electrically connected to the logic circuit 1130. The pads PAD may be electrically connected to the logic circuit 1130 through a routing interconnection structure 1135 extending from the memory structure ST1 to the peripheral structure ST2.

The controller 10 may include a processor 1210, a NAND controller 1220, and a host interface (I/F) 1230.

The processor 1210 may control the overall operation of the data storage system 1 including the controller 10. The processor 1210 may operate according to a predetermined firmware and may control the NAND controller 1220 to access the semiconductor device CH. The NAND controller 1220 may include a NAND interface (I/F) 1221 that processes communication with the semiconductor device CH. Through the NAND interface 1221, a control command for controlling the semiconductor device CH, data to be written to the memory cell transistors MCT of the semiconductor device CH, data to be read from the memory cell transistors MCT of the semiconductor device CH, or the like may be transmitted. The host interface 1230 may provide a communication function between the data storage system 1 and the external host HOST. When a control command is received from the external host HOST through the host interface 1230, the processor 1210 may control the semiconductor device CH in response to the control command.

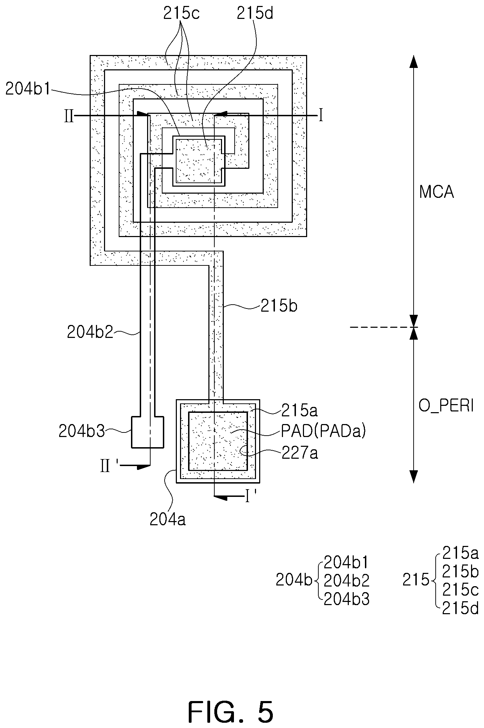

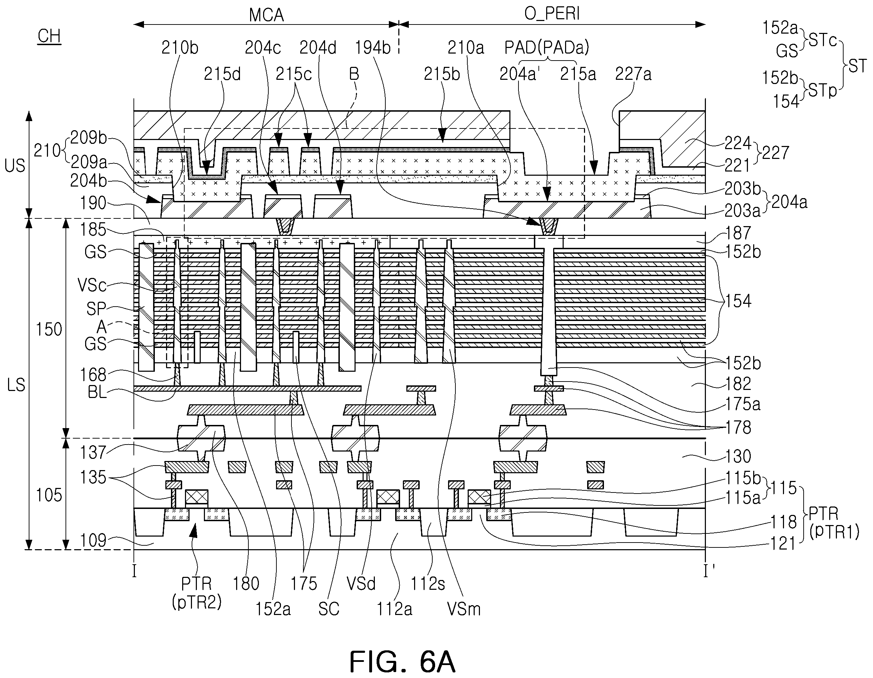

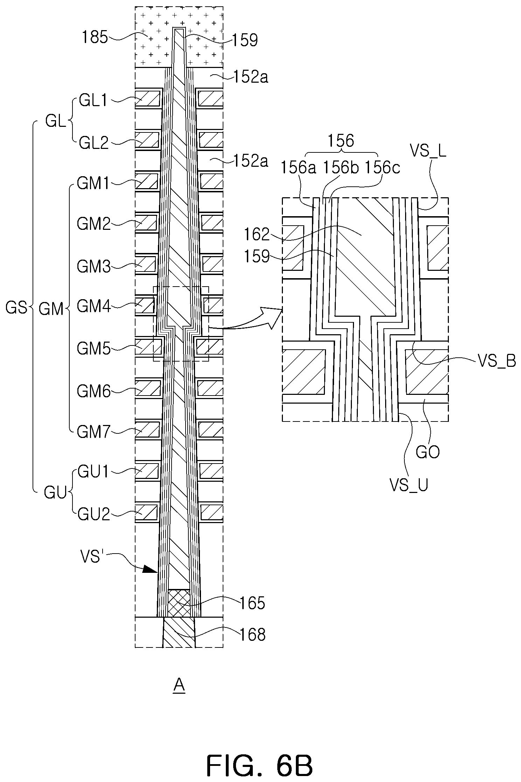

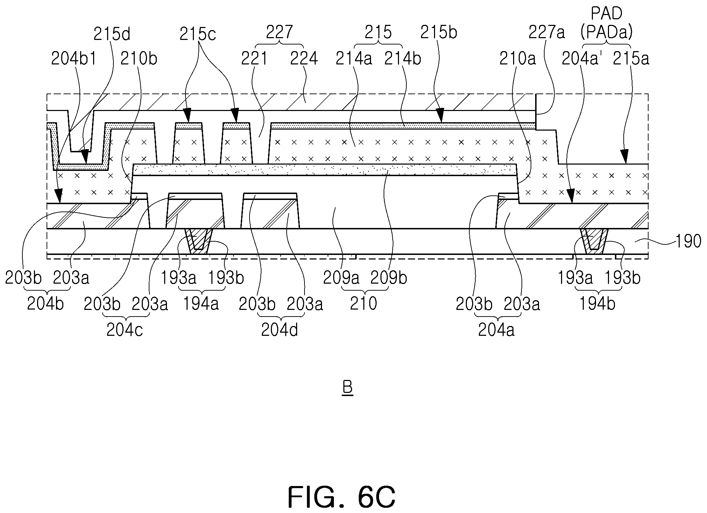

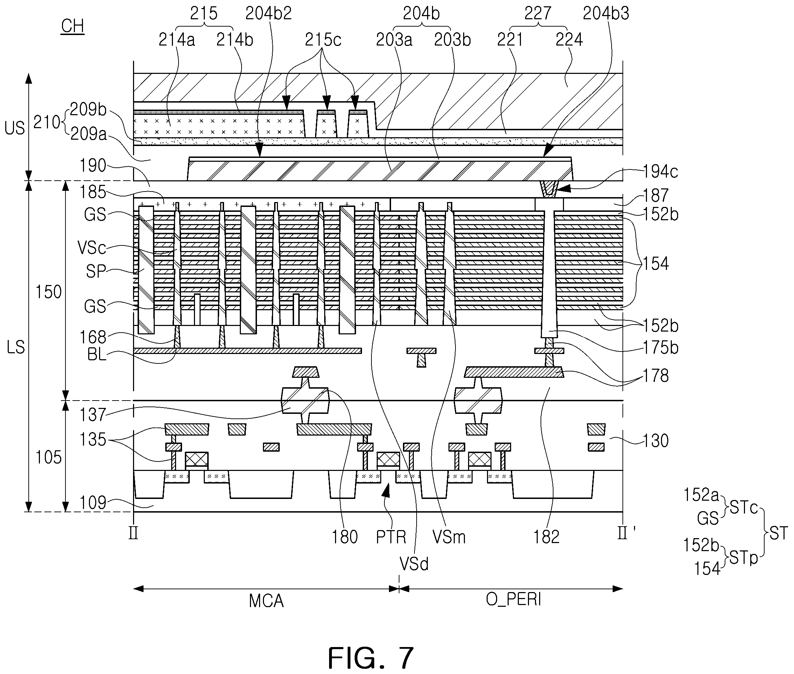

Next, with reference to FIGS. 5, 6A, 6B, 6C, and 7, an illustrative example of the semiconductor device CH described with reference to FIGS. 1 to 4 will be described. FIG. 5 is a plan view illustrating a portion of the semiconductor device CH, FIG. 6A is a cross-sectional view illustrating a region taken along line I-I' of FIG. 5, FIG. 6B is a partial enlarged view illustrating a region indicated by 'A' of FIG. 6A, FIG. 6C is a partial enlarged view illustrating a region indicated by 'B' of FIG. 6A, and FIG. 7 is a cross-sectional view illustrating a region taken along line II-II' of FIG. 5.

Referring to FIGS. 5, 6A, 6B, 6C, and 7 together with FIGS. 1 to 4, the semiconductor device CH may include a lower structure LS and an upper structure US on the lower structure LS.

The above-described lower structure LS may include a first structure 105 and a second structure 150 that vertically overlaps the first structure 105. The second structure 150 may be disposed on the first structure 105.

The second structure 150 and the upper structure US may constitute the memory structure ST1 described above, and the first structure 105 may constitute the peripheral structure ST2 described above.

The first structure 105 may include a substrate 109, peripheral active regions 112a on the substrate 109, and peripheral element isolation regions 112s that define the peripheral active regions 112a on the substrate 109. The substrate 109 may be a semiconductor substrate.

The first structure 105 may further include a peripheral circuit PTR on the substrate 109, a peripheral interconnection structure 135, first bonding pads 137, and an insulating structure 130.

The peripheral circuit PTR may include peripheral transistors pTR1 and pTR2. Each of the peripheral transistors pTR1 and pTR2 may include peripheral source/drain regions 118 spaced apart from each other within the peripheral active region 112a, a peripheral channel region 121 between the peripheral source/drain regions 118, and a peripheral gate 115 on the peripheral active region 112a. The peripheral gate 115 may include a peripheral gate dielectric layer 115a, and a peripheral gate electrode 115b on the peripheral gate dielectric layer 115a. The peripheral interconnection structure 135 may be embedded in the insulating structure 130 and may be electrically connected to the peripheral transistors pTR1 and pTR2. The first bonding pads 137 may have upper surfaces that are coplanar with the upper surface of the insulating structure 130 and may be electrically connected to the peripheral interconnection structure 135.

The second structure 150 may include a memory cell array area MCA and an outer peripheral area O_PERI adjacent to the memory cell array area MCA. For example, the outer peripheral area O_PERI may be outside the memory cell array area MCA.

The second structure 150 may include a stacked structure ST, and a source structure (or a common source structure) 185 and an insulating layer 187 disposed on the stacked structure ST.

The stacked structure ST may include a first stacked structure STc within the memory cell array area MCA and a second stacked structure STp disposed within the outer peripheral area O_PERI and adjacent to the first stacked structure STc.

The first stacked structure STc may include gate layers GS and first interlayer insulating layers 152a that are alternately and repeatedly stacked in a vertical direction.

The second stacked structure STp may include first insulating layers 154 disposed at substantially the same level as the gate layers GS, and second interlayer insulating layers 152b alternately and repeatedly stacked with the first insulating layers 154 and disposed at the same level as the first interlayer insulating layers 152a. The material of the first insulating layers 154 may be different from the material of the first and second interlayer insulating layers 152a and 152b. For example, the first insulating layers 154 may include silicon nitride, and the first and second interlayer insulating layers 152a and 152b may include silicon oxide.

The second stacked structure STp may be an insulating structure or an insulating region.

The gate layers GS may include a plurality of gate electrodes GL, GM and GU spaced apart from each other in a vertical direction. Among the plurality of gate electrodes GL, GM and GU and the first interlayer insulating layers 152a, the uppermost layer and the lowermost layer may be disposed as the interlayer insulating layers.

The plurality of gate electrodes GL, GM and GU may include one or a plurality of first gate electrodes GL, a plurality of intermediate gate electrodes GM disposed below the one or plurality of first gate electrodes GL, and one or a plurality of second gate electrodes GU disposed below the plurality of intermediate gate electrodes GM.

The one or a plurality of first gate electrodes GL may include a 1-1 gate electrode GL1 and a 1-2 gate electrode GL2 disposed below the 1-1 gate electrode GL1. The 1-1 and 1-2 gate electrodes GL1 and GL2 may be the first and second lower gate lines LL1 and LL2 described above with reference to FIG. 3.

The above-described plurality of intermediate gate electrodes GM may include the word lines WL described above with reference to FIG. 3. Therefore, the above-described plurality of intermediate gate electrodes GM may also be referred to as word lines.

The above-described plurality of intermediate gate electrodes GM may include a first intermediate gate electrode GM1, a second intermediate gate electrode GM2 below the first intermediate gate electrode GM1, a third intermediate gate electrode GM3 below the second intermediate gate electrode GM2, a fourth intermediate gate electrode GM4 below the third intermediate gate electrode GM3, a fifth intermediate gate electrode GM5 below the fourth intermediate gate electrode GM4, a sixth intermediate gate electrode GM6 below the fifth intermediate gate electrode GM5, and a seventh intermediate gate electrode GM7 below the sixth intermediate gate electrode GM6.

The one or more second gate electrodes GU may include a second-first gate electrode GU1 and a second-second gate electrode GU2 below the second-first gate electrode GU1. The second-first and second-second gate electrodes GU1 and GU2 may be the first and second upper gate lines UL1 and UL2 described above with reference to FIG. 3.

In example embodiments, the number of the plurality of gate electrodes GL, GM and GU illustrated in the drawing is an illustrative example, and the number of the plurality of gate electrodes GL, GM and GU may be different from the number illustrated.

The second structure 150 may further include a separation pattern SP penetrating the first stacked structure STc. The separation pattern SP may penetrate the plurality of gate electrodes GL, GM and GU (for example, in a vertical direction) and divide the plurality of gate electrodes GL, GM and GU in a horizontal direction.

The second structure 150 may further include a dielectric layer GO covering respective upper, side and lower surfaces of the plurality of gate electrodes GL, GM and GU.

The second structure 150 may further include vertical channel structures VSc. The vertical channel structures VSc may vertically penetrate the first stacked structure STc.

Each of the vertical channel structures VSc may include an insulating core region 162, a channel layer 159 on the outer side surface of the insulating core region 162, an data storage structure 156 on the outer side surface of the channel layer 159, and a pad layer 165 disposed on the insulating core region 162 and in contact with the channel layer 159.

The channel layer 159 may include a semiconductor material such as silicon. The pad layer 165 may include at least one of doped polysilicon, a metal nitride (for example, TiN, or the like), a metal (for example, W, or the like), and a metal-semiconductor compound (for example, TiSi, or the like). The data storage structure 156 may include a first dielectric layer 156a, a second dielectric layer 156c, and an data storage layer 156b between the first dielectric layer 156a and the second dielectric layer 156c. The first dielectric layer 156a may include at least one of silicon oxide and a high-κ dielectric. The second dielectric layer 156c may include silicon oxide or silicon oxide doped with impurities. The second dielectric layer 156c may be in contact with the channel layer 159.

The data storage layer 156b may include a material capable of trapping a charge and storing data, for example, silicon nitride. The data storage layer 156b may include regions capable of storing data in a semiconductor device such as a flash memory device.

In an example embodiment, the data storage structure 156 includes the data storage layer 156b capable of storing data by trapping a charge, but example embodiments are not limited thereto. For example, the data storage structure 156 may be an data storage structure used in a ferroelectric memory.

Each of the vertical channel structures VSc may include a lower vertical portion VS _L, an upper vertical portion VS_U on the lower vertical portion VS _L, and a junction portion VS_B between the lower vertical portion VS_L and the upper vertical portion VS_U.

In the vertical channel structures VSc, the junction portions VS_B may be disposed between the plurality of intermediate gate electrodes GM. For example, the junction portions VS_B may be disposed between the fourth intermediate gate electrode GM4 and the fifth intermediate gate electrode GM5 among the plurality of intermediate gate electrodes GM.

In the respective vertical channel structures VSc, the junction portions VS_B may have a side surface that is bent from the side of the lower vertical portion VS_L and the side of the upper vertical portion VS_U.

The source structure 185 may be disposed on the first stacked structure STc, and the insulating layer 187 may be disposed on the second stacked structure STp.

The source structure 185 may be the common source CSL described above. The source structure 185 may be electrically connected to the vertical channel structure VSc. The source structure 185 may be in contact with the vertical channel structure VSc. The source structure 185 may include a silicon layer having an N-type conductivity that is in contact with the channel layer 159 of the vertical channel structure VSc. According to an example embodiment, the source structure 185 may include a polysilicon layer and a metal layer on the polysilicon layer.

The second structure 150 may further include a vertical dummy pillar VSd and a vertical monitoring pillar VSm. The vertical dummy pillar VSd may penetrate the first stacked structure STc adjacent to the second stacked structure STp. The vertical monitoring pillar VSm may penetrate the second stacked structure STp adjacent to the first stacked structure STc.

The second structure 150 may further include a string separation pattern SC that penetrates the second gate electrodes GU in a vertical direction and divides the second gate electrodes GU in a horizontal direction.

The second structure 150 may further include an insulating structure 182 between the stacked structure ST and the first structure 105, and second bonding pads 180 that have a lower surface that is coplanar with the lower surface of the insulating structure 182 and are in contact with and bonded to the first bonding pads 137.

The second structure 150 may include the bit line BL described above. The bit line BL may be disposed below the first stacked structure STc and may be embedded in the insulating structure 182. The second structure 150 may further include a bit line contact plug 168 disposed between the bit line BL and the vertical channel structure VSc to electrically connect the bit line BL and the vertical channel structure VSc.

The second structure 150 may further include first and second contact plugs 175a and 175b penetrating the second stacked structure STp and the insulating layer 187. Each of the first and second contact plugs 175a and 175b may have a lower surface disposed at a lower level than a lowermost gate electrode among the gate layers GS and an upper surface disposed at a higher level than a uppermost gate electrode among the gate layers GS.

The second structure 150 may further include a first lower interconnection structure 175 electrically connected to the bit line BL and a second lower interconnection structure 178 electrically connected to the first and second contact plugs 175a and 175b. The first and second lower interconnection structures 175 and 178 may be electrically connected to the second bonding pads 180.

The second structure 150 may further include an inter-metal insulating layer 190 on the source structure 185 and the insulating layer 187, and conductive vias 194a, 194b and 194c penetrating the inter-metal insulating layer 190.

Each of the conductive vias 194a, 194b and 194c may include a via conductive layer 193a and a via barrier layer 193b covering a side surface and a lower surface of the via conductive layer 193a.

The conductive vias 194a, 194b and 194c may include a source conductive via 194a connected to the source structure 185, a first conductive via 194b connected to the first contact plug 175a, and a second conductive via 194c connected to the second contact plug 175b.

The first contact plug 175a and the first conductive via 194b electrically connected to each other may form a first contact structure, and the second contact plug 175b and the second conductive via 194c electrically connected to each other may form a second contact structure.

The upper structure US may include lower conductive patterns 204a, 204b, 204c and 204d disposed on the lower structure LS, disposed at the same level (i.e., may have upper surfaces that are coplanar and lower surfaces that are coplanar), and spaced apart from each other. Each of the lower conductive patterns 204a, 204b, 204c and 204d may include a first lower conductive layer 203a and a second lower conductive layer 203b having a thickness less than the thickness of the first lower conductive layer 203a, on the first lower conductive layer 203a. The first lower conductive layer 203a may include Al, but example embodiments are not limited thereto. For example, the first lower conductive layer 203a may include W or Mo. The second lower conductive layer 203b may include a metal nitride, such as TiN, TaN, or WN.

The lower conductive patterns 204a, 204b, 204c and 204d may include a first lower conductive pattern 204a, a second lower conductive pattern 204b, a third lower conductive pattern 204c, and a fourth lower conductive pattern 204d.

The first lower conductive pattern 204a may be electrically connected to the first contact plug 175a and the first conductive via 194b. The second lower conductive pattern 204b may be electrically connected to the second contact plug 175b and the second conductive via 194c. The third lower conductive pattern 204c may be electrically connected to the source conductive via 194a. The first lower conductive pattern 204a may be in contact with the upper surface of the first conductive via 194b. The second lower conductive pattern 204b may be in contact with the upper surface of the second conductive via 194c. The third lower conductive pattern 204c may be in contact with the upper surface of the source conductive via 194a. The fourth lower conductive pattern 204d may be an electrically isolated dummy pattern.

The second lower conductive pattern 204b may include a first connection region 204b1, a second connection region 204b3, and an intermediate region 204b2 between the first and second connection regions 204b1 and 204b3.

The upper structure US may further include a lower insulating structure 210 disposed on the lower structure LS and the lower conductive patterns 204a, 204b, 204c and 204d, and the lower insulating structure 210 may define openings 210a and 210b.

The lower insulating structure 210 may be disposed on the side surfaces of the lower conductive patterns 204a, 204b, 204c and 204d and may have an upper surface disposed at a higher level than the upper surfaces of the lower conductive patterns 204a, 204b, 204c and 204d. The lower insulating structure 210 may include a first lower insulating layer 209a and a second lower insulating layer 209b having a thickness less than that of the first lower insulating layer 209a on the first lower insulating layer 209a. The first lower insulating layer 209a may include an oxide such as silicon oxide, and the second lower insulating layer 209b may include a nitride such as silicon nitride.

The openings 210a and 210b of the lower insulating structure 210 may include a first opening 210a exposing at least a portion of the upper surface of the first lower conductive pattern 204a and a second opening 210b exposing at least a portion of the upper surface of the first connection region 204b1 of the second lower conductive pattern 204b.

In an example, the first opening 210a of the lower insulating structure 210 may expose a portion of the upper surface of the first lower conductive pattern 204a, and the second opening 210b of the lower insulating structure 210 may expose a portion of the upper surface of the first connection region 204b1 of the second lower conductive pattern 204b.

The first opening 210a of the lower insulating structure 210 may penetrate the second lower conductive layer 203b of the first lower conductive pattern 204a and expose the first lower conductive layer 203a of the first lower conductive pattern 204a. The second opening 210b of the lower insulating structure 210 may penetrate the second lower conductive layer 203b of the second lower conductive pattern 204b and expose the first lower conductive layer 203a of the second lower conductive pattern 204b.

The upper structure US may further include an upper conductive pattern 215. The upper conductive pattern 215 may include a first upper conductive layer 214a and a second upper conductive layer 214b having a thickness less than a thickness of the first upper conductive layer 214a on the first upper conductive layer 214a. The first upper conductive layer 214a may include Al, but example embodiments are not limited thereto. For example, the first upper conductive layer 214a may include W or Mo. The second upper conductive layer 214b may include a metal nitride such as TiN, TaN, or WN.

The upper conductive pattern 215 is disposed on the lower insulating structure 210, may be electrically connected to the first lower conductive pattern 204a exposed by the first opening 210a, and may be electrically connected to the second lower conductive pattern 204b exposed by the second opening 210b. For example, the upper conductive pattern 215 may include first portions 215b and 215c disposed on an upper surface of the lower insulating structure 210, a second portion 215a extending from the first portions 215b and 215c and contacting the upper surface of the first lower conductive pattern 204a exposed by the first opening 210a, and a third portion 215d extending from the first portions 215b and 215c and contacting the upper surface of the first connection region 204b1 of the second lower conductive pattern 204b exposed by the second opening 210b. For example, the first upper conductive layer 214a of the second portion 215a of the upper conductive pattern 215 may contact the first lower conductive layer 203a of the first lower conductive pattern 204a exposed by the first opening 210a, and the first upper conductive layer 214a of the third portion 215d of the upper conductive pattern 215 may contact the first lower conductive layer 203a of the second lower conductive pattern 204b exposed by the second opening 210b.

At least a portion of the first portions 215b and 215c of the upper conductive pattern 215 may have a spiral coil shape in a plan view. At least a portion of the first portions 215b and 215c of the upper conductive pattern 215 may include the inductor INT described above with reference to FIG. 4. At least a portion of the first portions 215b and 215c of the upper conductive pattern 215 may be configured to form the inductor INT.

The first portions 215b and 215c of the upper conductive pattern 215 may include a connecting portion 215b and an inductor portion 215c. The inductor portion 215c may have a spiral coil shape in a plan view and may include the inductor INT described above with reference to FIG. 4.

The upper conductive pattern 215 may be referred to as an inductor pattern.

To improve performance of the inductor INT, the thickness of the upper conductive pattern 215 may be greater than the thickness of each of the lower conductive patterns 204a, 204b, 204c and 204d.

The upper structure US may further include an upper insulating structure 227. The upper insulating structure 227 is disposed on the lower insulating structure 210 and the upper conductive pattern 215, and may define a pad opening 227a that exposes at least a portion of an upper surface of the second portion 215a of the upper conductive pattern 215. The upper insulating structure 227 covers the second upper conductive layer 214b of the upper conductive pattern 215, and the pad opening 227a of the upper insulating structure 227 penetrates the second upper conductive layer 214b of the upper conductive pattern 215 and may expose the first upper conductive layer 214a of the upper conductive pattern 215.

The second portion 215a of the upper conductive pattern 215 exposed by the pad opening 227a and the portion 204a' of the first lower conductive pattern 204a contacting the second portion 215a of the upper conductive pattern 215 below the second portion 215a of the upper conductive pattern 215 may form a pad PAD connected to an external connection structure 70 in FIG. 1. The pad PAD may be an input/output pad or a power pad described with reference to FIGS. 1 to 4 above. The pad PAD may be the first pad PADa described above with reference to FIGS. 1 to 4.

In an example, the pad PAD may vertically overlap the first contact plug 175a and the first conductive via 194b.

The upper insulating structure 227 may include a first upper insulating layer 221 and a second upper insulating layer 224 having a thickness greater than that of the first upper insulating layer 221 on the first upper insulating layer 221. The first upper insulating layer 221 may include silicon oxide or a low-κ dielectric having a dielectric constant lower than that of silicon oxide, and the second upper insulating layer 224 may include a polyimide-based material. For example, the second upper insulating layer 224 may include a photosensitive polyimide (PSPI) material.

To improve the performance of the inductor INT, in the inductor portion 215c, the space between the line portions of the spiral coil shape in the plane may be filled with the first upper insulating layer 221.

Hereinafter, various example embodiments of the semiconductor device CH will be described. The various example embodiments described below and the previously described embodiments may be combined to form an example embodiment. Hereinafter, the elements described above may be directly cited without a separate detailed description, or the description may be omitted. In addition, the elements described below that may be modified or replaced are described with reference to the drawings below, but the elements that may be modified, replaced, or added may be combined with each other or with the previously described elements to form a semiconductor device according to an example embodiment.

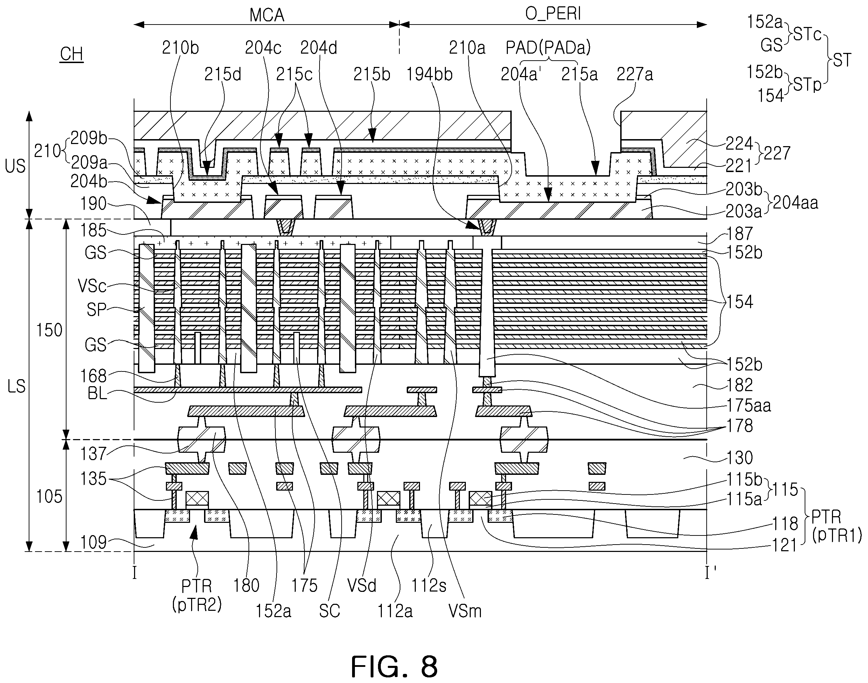

FIG. 8 is a cross-sectional view illustrating a region taken along line I-I' of FIG. 5 to describe a semiconductor device according to an example embodiment.

In an example embodiment, referring to FIGS. 5 and 8, the first contact plugs 175a and the first conductive vias 194b of FIG. 6A vertically overlapping with the pad PAD described above may be replaced with first contact plugs 175aa and first conductive vias 194bb that do not vertically overlap with the pad PAD, and the first lower conductive pattern 204a described above may be replaced with a first lower conductive pattern 204aa that extends to one side to be connected to the first contact plugs 175aa and the first conductive vias 194bb (for example, connected to or in contact with the upper surfaces of the first conductive vias 194bb).

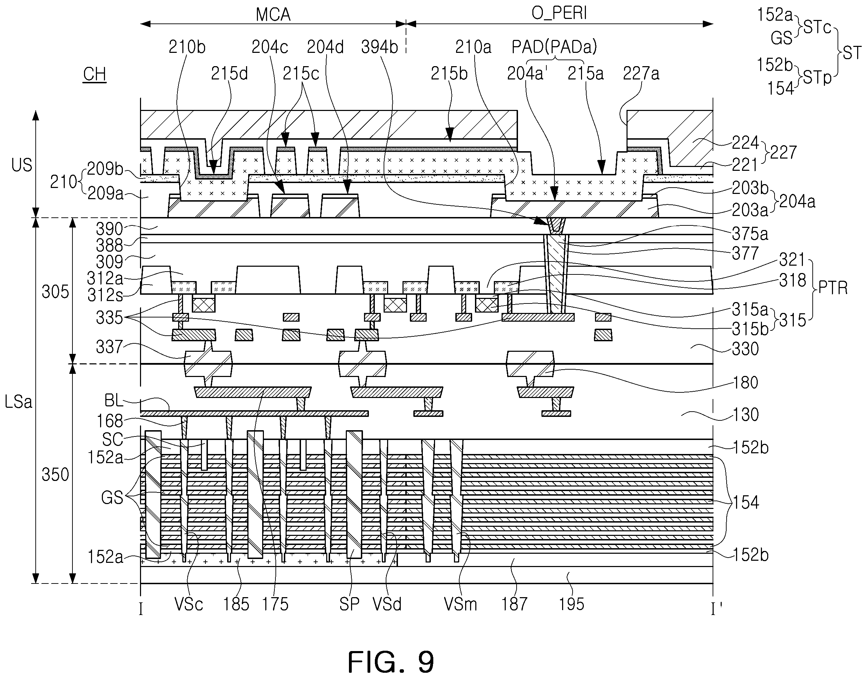

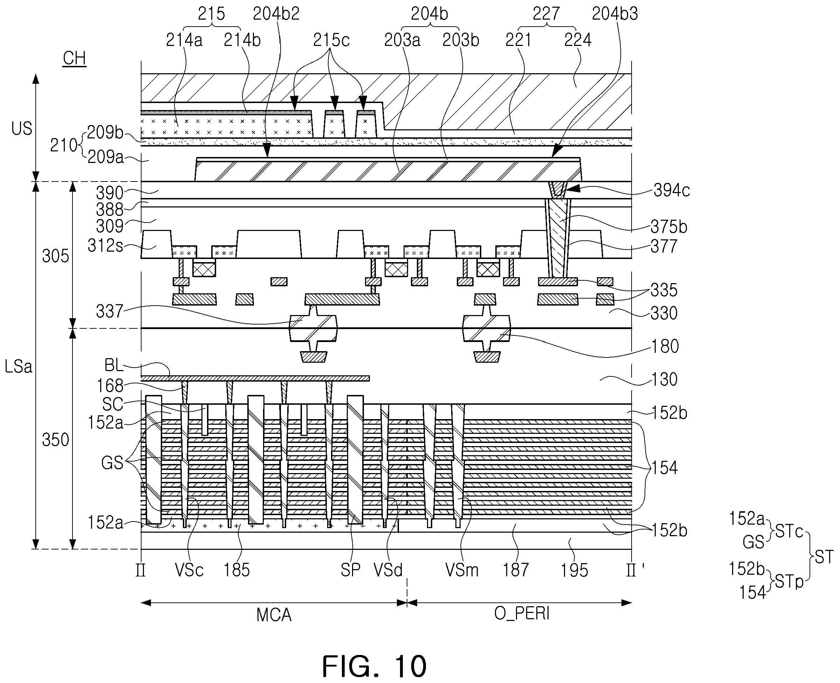

FIG. 9 is a cross-sectional view illustrating a region taken along line I-I' of FIG. 5 to describe a semiconductor device according to an example embodiment, and FIG. 10 is a cross-sectional view illustrating a region taken along line II-II' of FIG. 5 to describe a semiconductor device according to an example embodiment.

In an example embodiment, referring to FIGS. 5, 9, and 10, the lower structure LS described above with reference to FIGS. 6A, 6B, and 7 may be replaced with a lower structure LSa as in FIGS. 9 and 10. The lower structure LSa may include a first structure 305 and a second structure 350 vertically overlapping the first structure 305. The second structure 350 may be positioned below the first structure 305.

The first structure 305 may include a substrate 309, peripheral active regions 312a below the substrate 309, and peripheral isolation regions 312s defining the peripheral active regions 312a below the substrate 309. The substrate 309 may be a semiconductor substrate.

The first structure 305 may further include a peripheral circuit PTR, a peripheral interconnection structure 335, first bonding pads 337, and an insulating structure 330 disposed below the substrate 309.

The peripheral circuit PTR may include peripheral transistors. Each of the peripheral transistors of the peripheral circuit PTR may include peripheral source/drain regions 318 spaced apart from each other within the peripheral active region 312a, a peripheral channel region 321 between the peripheral source/drain regions 318, and a peripheral gate 315 below the peripheral active region 312a. The peripheral gate 315 may include a peripheral gate dielectric layer 315a, and a peripheral gate electrode 315b below the peripheral gate dielectric layer 315a. The peripheral interconnection structure 335 may be embedded in the insulating structure 330 and may be electrically connected to the peripheral circuit PTR. The first bonding pads 337 may have lower surfaces that are coplanar with the lower surface of the insulating structure 330 and may be electrically connected to the peripheral interconnection structure 335.

The first structure 305 may further include a first back insulating layer 388 disposed on the substrate 309 and a second back insulating layer 390 on the first back insulating layer 388.

The first structure 305 may further include a first contact plug 375a penetrating the first back insulating layer 388 and the substrate 309 and electrically connected to the peripheral interconnection structure 335, and a first conductive via 394b penetrating the second back insulating layer 390 and electrically connected to the first contact plug 375a.

The first structure 305 may further include a second contact plug 375b penetrating the first back insulating layer 388 and the substrate 309 and electrically connected to the peripheral interconnection structure 335, and a second conductive via 394c penetrating the second back insulating layer 390 and electrically connected to the second contact plug 375b.

The first structure 305 may further include an insulating spacer 377 on the side surfaces of the first and second contact plugs 375a and 375b.

The first conductive via 394b and the first contact plug 375a may form a first contact structure, and the second conductive via 394c and the second contact plug 375b may form a second contact structure.

The first contact structure (including the first conductive via 394b and the first contact plug 375a) may be in contact with and connected to the first lower conductive pattern 204a of the upper structure US described above. For example, the first contact plug 375a may be in contact with and connected to the first conductive via 394b, and the first conductive via 394b may be in contact with and connected to the first lower conductive pattern 204a. The second contact structure (including the second conductive via 394c and the second contact plug 375b) may be in contact with and connected to the second lower conductive pattern 204b of the upper structure US described above. For example, the second contact plug 375b may be in contact with and connected to the second conductive via 394c, and the second conductive via 394c may be in contact with and connected to the second lower conductive pattern 204b.

In an example embodiment, the second back insulating layer 390 and the first and second conductive vias 394b, 394c may be omitted. The first and second contact plugs 375a and 375b may be in contact with and connected to the first and second lower conductive patterns 204a and 204b, respectively.

The second structure 350 may include the memory cell array area MCA as described above and the outer peripheral area O_PERI adjacent to the memory cell array area MCA.

The second structure 350 may include a stacked structure ST, a source structure 185, and an insulating layer 187.

The stacked structure ST of the second structure 350 may be a structure in which the stacked structure ST of the second structure 150 described above with reference to FIGS. 6A, 6B, and 7 is flipped upside down (i.e., inverted). Accordingly, the stacked structure ST of the second structure 350 may include the first stacked structure STc and the second stacked structure STp that are substantially the same as those described above. Accordingly, the stacked structure ST may include the first stacked structure STc within the memory cell array area MCA and the second stacked structure STp that is disposed within the outer peripheral area O_PERI and is adjacent to the first stacked structure STc.

The second structure 350 may further include the separation pattern SP, the vertical channel structure VSc, the vertical dummy pillar VSd, and the vertical monitoring pillar VSm penetrating the first stacked structure STc substantially the same as described above.

In the second structure 350, the structure including the stacked structure ST, the separation pattern SP, the vertical channel structure VSc, the vertical dummy pillar VSd, and the vertical monitoring pillar VSm may be understood as a structure in which the structure including the stacked structure ST, the separation pattern SP, the vertical channel structure VSc, the vertical dummy pillar VSd, and the vertical monitoring pillar VSm in the second structure 150 is inverted.

The source structure 185 may be disposed below the first stacked structure STc, and the insulating layer 187 may be disposed below the second stacked structure STp. The source structure 185 may be electrically connected to the vertical channel structure VSc.

The second structure 350 may further include a protective insulating layer 195 below the source structure 185 and the insulating layer 187.

The second structure 350 may further include a string separation pattern SC that penetrates the second gate electrodes GU in a vertical direction and divides the second gate electrodes GU in a horizontal direction.

The second structure 350 may further include an insulating structure 130 between the stacked structure ST and the first structure 305, and second bonding pads 180 that have an upper surface that is coplanar with the upper surface of the insulating structure 130 and are in contact with and bonded to the first bonding pads 337.

The second structure 350 may include the bit line BL described above. The bit line BL may be disposed on the first stacked structure STc and may be embedded in the insulating structure 130. The second structure 350 may further include a bit line contact plug 168 that is disposed between the bit line BL and the vertical channel structure VSc and electrically connects the bit line BL and the vertical channel structure VSc.

The second structure 350 may further include a lower interconnection structure 175. The lower interconnection structure 175 may be electrically connected to the second bonding pads 180.

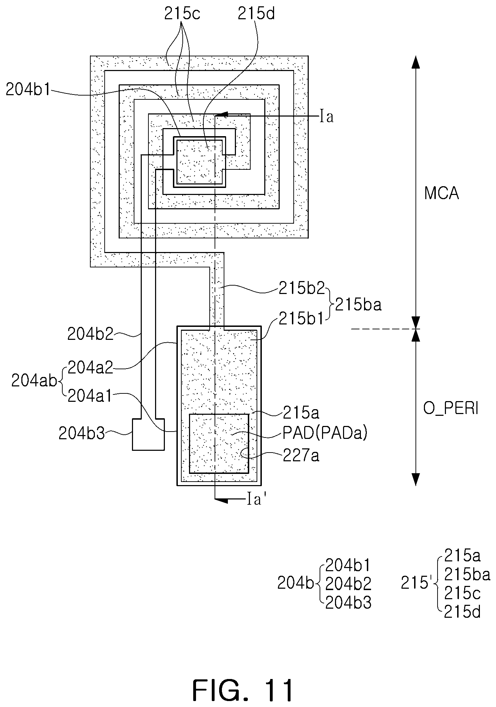

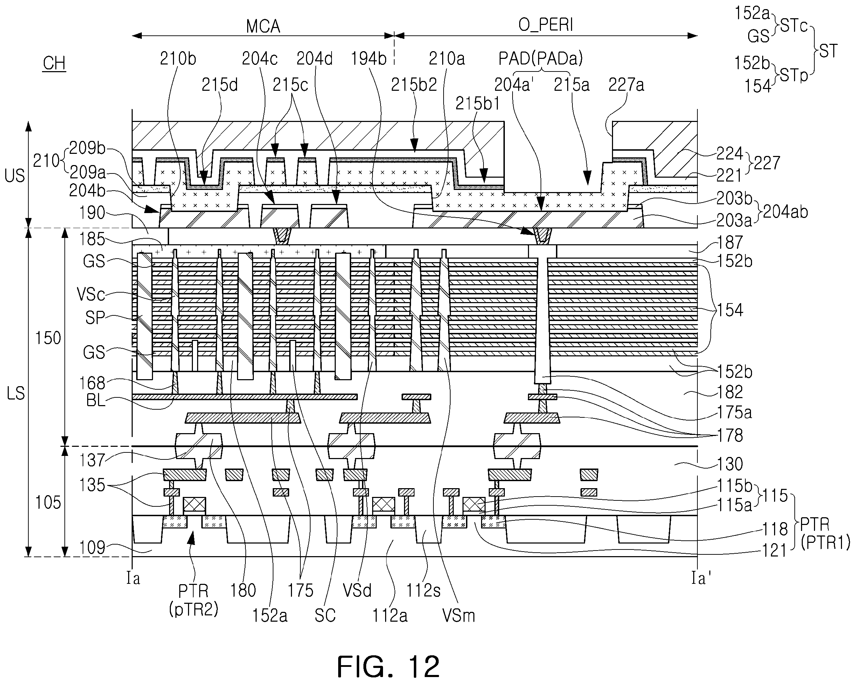

FIG. 11 is a plan view illustrating a portion of a semiconductor device according to an example embodiment, and FIG. 12 is a cross-sectional view illustrating a region taken along line Ia-Ia' of FIG. 11 to describe the semiconductor device according to an example embodiment.

In an example embodiment, referring to FIGS. 11 and 12, in the upper structure US described above, the first lower conductive pattern 204a in FIGS. 5, 6A, and 6C may be replaced with a first lower conductive pattern 204ab including a first lower portion 204a1 having substantially the same size as the first lower conductive pattern 204a described above and a second lower portion 204a2 extending from the first lower portion 204a1.

In the upper structure US described above, the upper conductive pattern 215 including the connecting portion 215b in FIGS. 5, 6A, and 6C may be replaced with an upper conductive pattern 215' including the connecting portion 215ba as in FIGS. 11 and 12.

The connecting portion 215ba may include a first connecting portion 215b1 that contacts the second lower portion 204a2 and a second connecting portion 215b2 that extends from the first connecting portion 215b1 onto the upper surface of the lower insulating structure 210.

Therefore, the contact area between the upper conductive pattern 215' including the connecting portion 215ba and the first lower conductive pattern 204ab including the first lower portion 204a1 and the second lower portion 204a2 may be increased, so that the contact resistance between the upper conductive pattern 215' and the first lower conductive pattern 204ab may be reduced. Accordingly, the electrical performance of the semiconductor device CH may be improved.

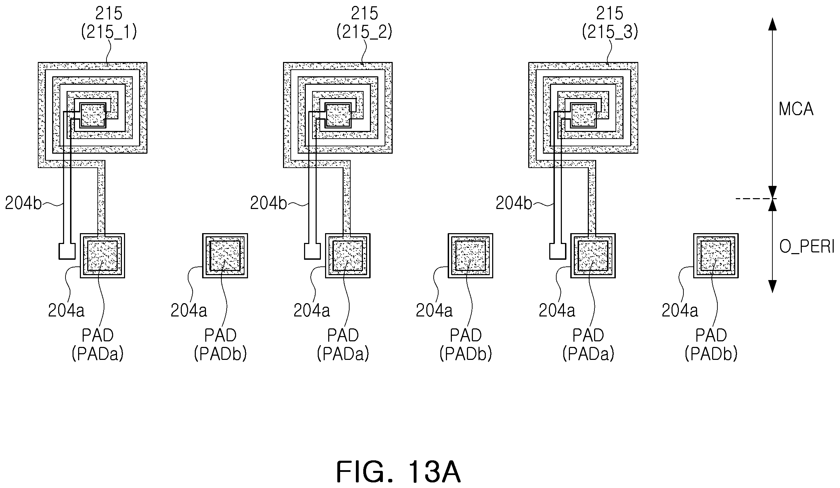

FIG. 13A is a plan view illustrating a portion of the semiconductor device including pads PAD according to example embodiments.

In an example embodiment, referring to FIG. 1, FIG. 4 and FIG. 13A, as described above, the upper conductive pattern 215 may include an inductor INT and may be an inductor pattern. The pads PAD disposed within the outer peripheral area O_PERI may include first pads PADa electrically connected to the inductor pattern 215 and second pads PADb not electrically connected to the inductor pattern 215, as described above.

Among the first pads PADa and the second pads PADb, any pair of the first pads PADa and the second pads PADb may be adjacent to each other. The first pads PADa and the second pads PADb may be arranged alternately in one direction, and the inductor patterns 215 connected to the first pads PADa may include a first inductor pattern 215_1, a second inductor pattern 215_2, and a third inductor pattern 215_3 arranged sequentially in one direction. By arranging the first pad PADa and the second pad PADb adjacent to each other, a space in which the inductor patterns 215 may be disposed may be secured.

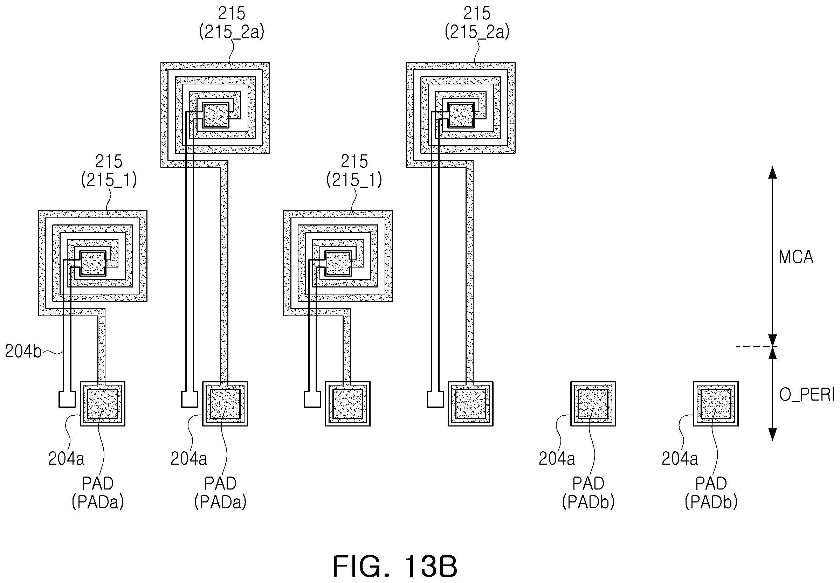

FIG. 13B is a plan view illustrating a portion of a semiconductor device including pads PAD according to example embodiments.

In an example embodiment, referring to FIG. 1 and FIG. 13B, among the first pads PADa and the second pads PADb described above, the first pads PADa may be disposed adjacent to each other.

The inductor patterns 215 described above may include a first inductor pattern 215_1 and a second inductor pattern 215_2a respectively connected to the first pads PADa adjacent to each other.

The inductor of the first inductor pattern 215_1 may be disposed on the memory cell array area MCA at a position separated from the outer peripheral area O_PERI by a first distance, and the inductor of the second inductor pattern 215_2a may be disposed on the memory cell array area MCA at a position separated from the outer peripheral area O _PERI by a second distance greater than the first distance. Accordingly, on the memory cell array area MCA, the inductor patterns 215 may be arranged in a zigzag shape, thereby securing space for disposing the inductors of the inductor patterns 215.

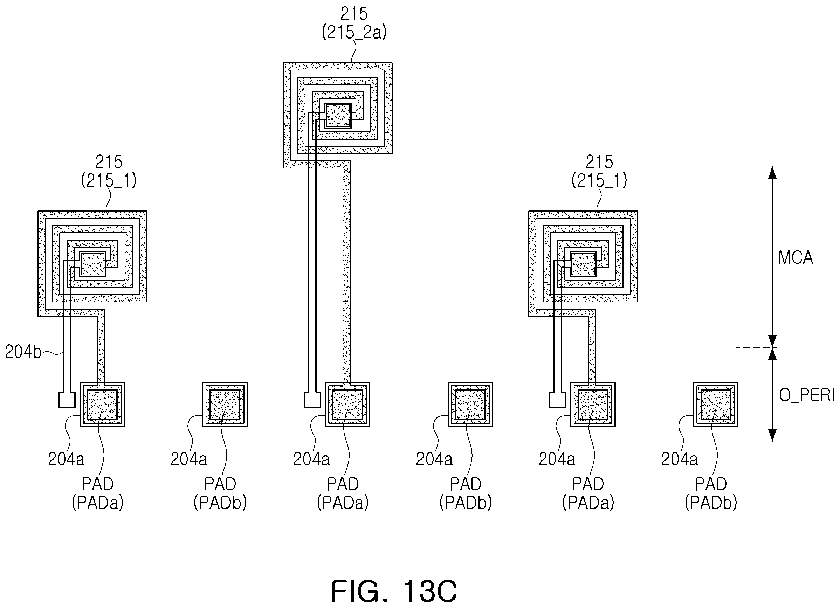

FIG. 13C is a plan view illustrating a portion of a semiconductor device including the pads PAD in FIG. 1.

In an example embodiment, referring to FIG. 1 and FIG. 13C, the first pads PADa and the second pads PADb described above may be arranged alternately in one direction.

The inductor patterns 215 electrically connected to the first pads PADa may include a first inductor pattern 215_1 and a second inductor pattern 215_2a adjacent to each other.

The inductor of the first inductor pattern 215_1 may be disposed on the memory cell array area MCA at a position spaced apart from the outer peripheral area O_PERI by a first distance, and the inductor of the second inductor pattern 215_2a may be disposed on the memory cell array area MCA at a position spaced apart from the outer peripheral area O_PERI by a second distance greater than the first distance. Accordingly, on the memory cell array area MCA, the inductor patterns 215 may be arranged in a zigzag shape, and thus, a space for placing the inductor patterns 215 may be secured.

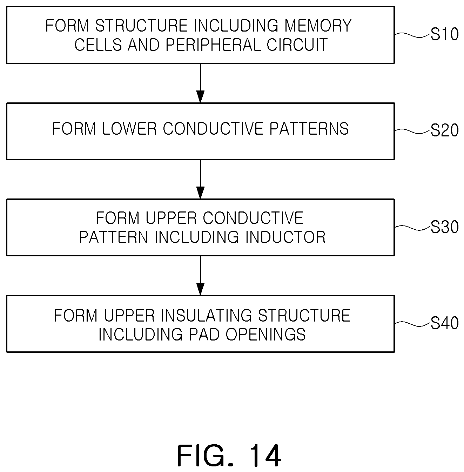

Next, with reference to FIG. 14, an illustrative example of a method of forming a semiconductor device according to an example embodiment will be described.

Referring to FIG. 14 together with FIG. 6A, FIG. 6B, FIG. 6C, and FIG. 7, a structure including memory cells and a peripheral circuit may be formed (S10). The structure may be the lower structure LS as in FIG. 6A and FIG. 7 described above, or the lower structure LSa as in FIG. 9 and FIG. 10. The lower conductive patterns (204a, 204b, 204c and 204d described above with reference to FIGS. 5 to 7) may be formed (S20). The lower insulating structure 210 having openings 210a and 210b may be formed on the lower conductive patterns (see 204a, 204b, 204c and 204d described above with reference to FIGS. 5 to 7). The upper conductive pattern (215 described above with reference to FIGS. 5 to 7) including an inductor may be formed (S30). The upper conductive pattern (215 described above with reference to FIGS. 5 to 7) may include an inductor portion (215c described above with reference to FIG. 5) that may constitute an inductor.

The upper conductive pattern 215 is formed on the lower insulating structure 210 and may be in contact with portions, exposed by the openings 210a, of the first lower conductive pattern 204a among the lower conductive patterns 204a, 204b, 204c and 204d described above with reference to FIGS. 5 to 7. An upper insulating structure 227 having pad openings 227a described above with reference to FIG. 6A may be formed (S40). The second portion of the upper conductive pattern 215 exposed by the pad openings 227a and the portion of the first lower conductive pattern 204a that is in contact with the upper conductive pattern 215 below the portion of the upper conductive pattern 215 may form a pad PAD connected to an external connection structure 70 described above with reference to FIG. 1.

As set forth above, according to example embodiments, a semiconductor device including an inductor pattern electrically connected to a pad, which may be an input/output pad or a power pad, and a data storage system including the same may be provided. By connecting the inductor pattern including an inductor to the pad as described above, in the semiconductor device, signal distortion in high-speed data transmission may be reduced, possibility of data loss or error occurrence may be reduced, signal quality in signal transmission may be improved, the bandwidth of a signal may be expanded so that more data may be transmitted faster, and/or noise in a power line in a power supply circuit may be reduced. Therefore, the performance of a semiconductor device may be improved.

While aspects of example embodiments have been particularly shown and described, it will be understood that various changes in form and details may be made therein without departing from the scope of the following claims.

## Claims

1. A semiconductor device comprising:
a lower structure (LS; LSa) comprising a first structure (105; 305) comprising a peripheral circuit, and a second structure (150; 350) comprising a memory cell array area (MCA) and an outer peripheral area (O_ PERI) outside the memory cell array area (MCA), the second structure (150; 350) vertically overlapping the first structure (105; 305); and
an upper structure (US) on the lower structure (LS; LSa),
wherein the upper structure (US) comprises:
a first lower conductive pattern (204a; 204aa; 204ab);
a second lower conductive pattern (204b), provided at a same level as the first lower conductive pattern (204a; 204aa; 204ab), and comprising a first connection region (204b1), a second connection region (204b3), and an intermediate region (204b2) between the first connection region (204b1) and the second connection region (204b3);
a lower insulating structure (210) provided on the lower structure (LS; LSa), on side surfaces of the first lower conductive pattern (204a; 204aa; 204ab) and the second lower conductive pattern (204b), having an upper surface at a level farther from the lower structure (LS; LSa) than upper surfaces of the first lower conductive pattern (204a; 204aa; 204ab) and the second lower conductive pattern (204b), and defining a first opening (210a) exposing at least a portion of an upper surface of the first lower conductive pattern (204a; 204aa; 204ab) and a second opening (210b) exposing at least a portion of an upper surface of the first connection region (204b1) of the second lower conductive pattern (204b);
an upper conductive pattern (215; 215') comprising a first portion (215b, 215c) provided on an upper surface of the lower insulating structure (210), a second portion (215a) extending from the first portion (215b, 215c) and contacting the upper surface of the first lower conductive pattern (204a; 204aa; 204ab) exposed by the first opening (210a), and a third portion (215d )extending from the first portion (215b, 215c) and contacting the upper surface of the first connection region (204b1) of the second lower conductive pattern (204b) exposed by the second opening (210b); and
an upper insulating structure (227) provided on the upper conductive pattern (215; 215') and defining a pad opening (227a) exposing at least a portion of an upper surface of the second portion (215a) of the upper conductive pattern (215; 215'), and
wherein at least a portion of the first portion (215b, 215c) of the upper conductive pattern (215; 215') has a spiral coil shape in a plan view.

2. The semiconductor device of claim 1, wherein the at least a portion of the first portion (215b, 215c) of the upper conductive pattern (215; 215') forms an inductor.

3. The semiconductor device of claim 1 or 2, wherein the upper conductive pattern (215; 215') exposed by the pad opening (227a) and the first lower conductive pattern (204a; 204aa; 204ab) below the upper conductive pattern (215; 215') form an input/output pad connected to an external connection structure.

4. The semiconductor device of any one of claims 1 to 3, wherein a thickness of the upper conductive pattern (215; 215') is greater than a thickness of each of the first lower conductive pattern (204a; 204aa; 204ab) and the second lower conductive pattern (204b).

5. The semiconductor device of any one of claims 1 to 4, wherein the second structure (150) further comprises:
a first stacked structure (STc) comprising gate electrodes (GS) vertically spaced apart from each other and stacked within the memory cell array area (MCA);
a vertical channel structure (VSc) penetrating the first stacked structure (STc);
a bit line (BL) electrically connected to the vertical channel structure (VSc), the bit line (BL) being below the first stacked structure (STc); and
a common source structure (185) electrically connected to the vertical channel structure (VSc), the common source structure (185) being on the first stacked structure (STc).

6. The semiconductor device of claim 5, wherein the first structure (105) is provided below the second structure (150).

7. The semiconductor device of claim 5 or 6, wherein the second structure (150) further comprises a first contact structure (175a, 194b) and a second contact structure (175b, 194c) provided within the outer peripheral area (O_PERI) and spaced apart from each other, and
wherein each of the first contact structure (175a, 194b) and the second contact structure (175b, 194c) comprises a contact plug (175a, 175b) having a lower surface provided at a level closer to the first structure (105) than a lowermost gate electrode among the gate electrodes (GS) and an upper surface provided at a level farther from the first structure (105) than an uppermost gate electrode among the gate electrodes (GS).

8. The semiconductor device of any one of claims 1 to 4, wherein the second structure (350) further comprises:
a first stacked structure (STc) comprising gate electrodes (GS) vertically spaced apart from each other and stacked within the memory cell array area (MCA);
a vertical channel structure (VSc) penetrating the first stacked structure (STc);
a bit line (BL) electrically connected to the vertical channel structure (VSc), the bit line (BL) being on the first stacked structure (STc); and
a source structure (185) electrically connected to the vertical channel structure (VSc), the source structure (185) being below the first stacked structure (STc), and
wherein the first structure (305) is provided on the second structure (350).

9. The semiconductor device of claim 8, wherein the first structure (105; 305) further comprises:
a semiconductor substrate (309);
a peripheral interconnection structure (335) below the semiconductor substrate (309);
a back insulating layer (390) on the semiconductor substrate (309);
a first contact structure (375a, 394b) penetrating the semiconductor substrate (309) and the back insulating layer (390) and electrically connected to the peripheral interconnection structure (335); and
a second contact structure (375b, 394c) penetrating the semiconductor substrate (309) and the back insulating layer (390) and electrically connected to the peripheral interconnection structure (335),
wherein the first contact structure (375a, 394b) contacts a lower surface of the first lower conductive pattern (204a), and
wherein the second contact structure (375b, 394c) contacts a lower surface of the second connection region (204b3) of the second lower conductive pattern (204b).

10. The semiconductor device of any one of claims 1 to 6 or of claim 8 wherein the second structure (150; 350) further comprises a first contact structure (175a, 194b; 375a, 394b) and a second contact structure (175b, 194c; 375b, 394c) provided within the outer peripheral area (O_PERI) and spaced apart from each other,
wherein the first contact structure (175a, 194b; 375a, 394b) contacts a lower surface of the first lower conductive pattern (204a; 204aa; 204ab), and
wherein the second contact structure (175b, 194c; 375b, 394c) contacts a lower surface of the second connection region (204b3) of the second lower conductive pattern (204b).

11. The semiconductor device of any one of claims 1 to 10, wherein each of the first lower conductive pattern (204a; 204aa; 204ab) and the second lower conductive pattern (204b) comprises a first lower conductive layer (203a) and a second lower conductive layer (203b) having a thickness less than a thickness of the first lower conductive layer (203a), and
wherein the upper conductive pattern (215; 215') comprises a first upper conductive layer (214a) and a second upper conductive layer (214b) having a thickness less than a thickness of the first upper conductive layer (214a), the second upper conductive layer (214b) being on the first upper conductive layer (214a).

12. The semiconductor device of claim 11, wherein the upper insulating structure (227) covers the second upper conductive layer (214b) of the upper conductive pattern (215; 215'), and
wherein the pad opening (227a) penetrates the second upper conductive layer of the upper conductive pattern (215; 215') and exposes the first upper conductive layer (214a) of the upper conductive pattern (215; 215').

13. The semiconductor device of claim 12, wherein the lower insulating structure (210) covers the second lower conductive layer (203b) of each of the first lower conductive pattern (204a; 204aa; 204ab) and the second lower conductive pattern (204b),
wherein the first opening (210a) penetrates the second lower conductive layer (203b) of the first lower conductive pattern (204a; 204aa; 204ab) and exposes the first lower conductive layer (203a) of the first lower conductive pattern (204a; 204aa; 204ab),
wherein the second opening (210b) penetrates the second lower conductive layer (203b) of the second lower conductive pattern (204b) and exposes the first lower conductive layer (203a) of the second lower conductive pattern (204b), and
wherein the first upper conductive layer (214a) of the upper conductive pattern (215; 215') contacts the first lower conductive layer (203a) of the first lower conductive pattern (204a; 204aa; 204ab) exposed by the first opening (210a) and the first lower conductive layer (203a) of the second lower conductive pattern (204b) exposed by the second opening (210b).

14. The semiconductor device of any one of claims 1 to 13, wherein the lower insulating structure (210) comprises a first lower insulating layer (209a) and a second lower insulating layer (209b) having a thickness less than a thickness of the first lower insulating layer (209a), the second lower insulating layer (209b) being on the first lower insulating layer (209a).

15. A data storage system comprising:
a semiconductor device (CH) according to any one of the preceding claims, wherein the semiconductor device(CH) comprises an input/output pad (PAD); and
a controller (10) electrically connected to the semiconductor device (CH) through the input/output pad (PAD) and configured to control the semiconductor device (CH).
